# EUROPÄISCHE PATENTSCHRIFT

(11) **EP 2 691 981 B1**
(45) Veröffentlichungstag und Bekanntmachung des Hinweises auf die Patenterteilung: **24.10.2018**
(21) Anmeldenummer: 12713916.0
(22) Anmeldetag: 21.03.2012
(51) Int. Cl.: H01L 21/56, H01L 23/13, H01L 23/36, H01L 23/31, H01L 23/40, H01L 23/473

(54) **ELEKTRONIKMODUL SOWIE VERFAHREN ZU DESSEN HERSTELLUNG**
ELECTRONIC MODULE AND METHOD FOR THE PRODUCTION THEREOF
MODULE ÉLECTRONIQUE AINSI QUE SON PROCÉDÉ DE FABRICATION

(30) Priorität: 29.03.2011 DE 102011006329
(43) Veröffentlichungstag der Anmeldung: 05.02.2014
(73) Patentinhaber: Robert Bosch GmbH, 70442 Stuttgart (DE)
(72) Erfinder: KADEN, Thomas, 71701 Schwieberdingen (DE); LEHTONEN, Paeivi, 70736 Fellbach (DE); BEHRENS, Tim, 25541 Brunsbuettel (DE)
(86) Internationale Anmeldenummer: PCT/EP2012/055025
(87) Internationale Veröffentlichungsnummer: WO 2012/130696

(56) Entgegenhaltungen:
- WO-A1-2010/084540
- WO-A1-2010/143599
- DE-A1-102006 006 175
- US-A1- 2003 034 557
- US-A1- 2004 046 248
- US-A1- 2004 233 637
- US-A1- 2011 031 608

## Beschreibung

### Stand der Technik

Die vorliegende Erfindung betrifft ein Elektronikmodul, wie beispielsweise eine Getriebesteuerung für Fahrzeuge, sowie ein Verfahren zu dessen Herstellung.

Aus der DE 10 2006 007 303 A1 ist ein Elektronikmodul in Form einer Leiterplatte bekannt, die bei einer Ausführungsform ein Wärmeableitelement aufweist, das eine in ein Verguss-Abdeckelement eingeformte, ein Kühlmedium führende Kühlschlange ist. Vorzugsweise erstreckt sich hierbei die Kühlschlange mehrfach geschlängelt in einer zur Leiterplattenebene parallelen Ebene innerhalb des in dem Verguss-Abdeckelement maximal zur Verfügung stehenden Raumes. Eine derartige Anordnung ist insofern verbesserungsbedürftig, als es wünschenswert ist, dass das Kühlmedium nicht innerhalb des Elektronikmoduls geführt wird, da damit der Gesamtaufbau des Elektronikmoduls sehr aufwendig wird.

Ferner ist aus der US 2003/0034557 A1 ein Elektronikmodul mit dem Merkmals des Oberbegriffs des Anspruchs 1 bekannt.

### Offenbarung der Erfindung

Das erfindungsgemäße Elektronikmodul mit den Merkmalen des Anspruches 1 weist demgegenüber den Vorteil auf, dass ein kostengünstig und leicht bestückbares Modul bereitgestellt werden kann, das im Übrigen auch auf Pasten- oder Folienhandling bei der Montage des Elektronikmoduls verzichten kann.

Ferner wird durch den vertieften Zentralbereich der Trägerplatte erreicht, dass alle Bauelemente sehr nah am Boden des Elektronikmoduls angeordnet werden können, was die Entwärmungspfade verkürzt und damit die Kühlung effizienter gestaltet, da eine direkte Entwärmung in das Kühlmedium, wie insbesondere Luft oder Kühlwasser, möglich ist.

Ferner ergibt sich auch für den Kühler der Vorteil eines einfachen und kompakten Kühleraufbaues, wobei es möglich ist, mehrere Elektronikmodule in einem Kühler anzuordnen.

Insgesamt ergibt sich somit sowohl für den Aufbau des Elektronikmoduls als auch für den Aufbau des Kühlers ein erheblicher Kostenvorteil.

Darüber hinaus ist es möglich, als Moldmasse vorzugsweise eine Masse auf Cyanatesterbasis zu verwenden, die Einsatztemperaturen bis zu 250°C ermöglicht. Somit können die erfindungsgemäßen Elektronikmodule auch in Umgebungen eingesetzt werden, die die Werkstoffe deutlich höher belasten.

Weiter ist der Teil des Vergussgehäuses, der den vertieften Zentralbereich der Trägerplatte umgibt, mit einer Dichteinrichtung versehen.

Die Unteransprüche zeigen bevorzugte Weiterbildungen der Erfindung.

Diese Dichteinrichtung kann, in Längsrichtung des Elektronikmoduls gesehen, einen radialen und einen longitudinalen Wandabschnitt aufweisen, die zwei Dichtflächen bilden, so dass das erfindungsgemäße Elektronikmodul in Ausnehmungen des Kühlmantels eingesetzt werden kann, ohne dass weitere Dichtmaterialien verwendet werden müssten. Hierbei bildet das Elektronikmodul, das vorzugsweise mit zusätzlichen Dichtelementen, wie beispielsweise Dichtlippen, Dichthinterschnitten oder Dichtkanten, versehen werden kann, eine Art Dichtstopfen, der die Öffnungen des Kühlgehäuses vor allem dann dicht verschließt, wenn als Kühlmedium Wasser Verwendung findet.

Um die Wärmeableitung weiter verbessern zu können, kann das Vergussgehäuse an seiner Unterseite mit Wärmeableitelementen versehen sein, wie beispielsweise Kühlrippen oder andere Kühlgeometrien, die es möglich machen, die Oberfläche des Elektronikmoduls, die dem Kühlmedium unmittelbar ausgesetzt ist, zu vergrößern.

Durch das Vorsehen der Vertiefung in der Trägerplatte wird ferner erreicht, dass die dem Kühlmedium zugewandte Wandstärke des Vergussgehäuses des erfindungsgemäßen Elektronikmoduls wesentlich dünner ausgestaltet werden kann, als die dem Kühlmedium abgewandte Wandstärke, was die Kühleffizienz weiter erhöht.

Zur Befestigung des Elektronikmoduls am Kühlgehäuse sind beispielsweise Klammern oder Schrauben denkbar, die einfach herzustellende und zu montierende Befestigungseinrichtungen darstellen.

In den Ansprüchen 7 bis 9 ist ferner ein Verfahren zur Herstellung des erfindungsgemäßen Elektronikmoduls definiert.

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine schematisch vereinfachte Darstellung einer Anordnung mehrerer Elektronikmodule (im Beispielsfalle vier Elektronikmodule), die auf einem Kühlergehäuse angeordnet sind,
- Figur 2: eine schematisch vereinfachte Schnittdarstellung durch eine erste Ausführungsform eines Elektronikmoduls,
- Figur 3: eine der Figur 2 entsprechende Darstellung einer zweiten Ausführungsform des erfindungsgemäßen Elektronikmoduls, und
- Figur 4: eine den Figuren 2 und 3 entsprechende Darstellung einer dritten Ausführungsform des erfindungsgemäßen Elektronikmoduls.

### Bevorzugte Ausführungsformen der Erfindung

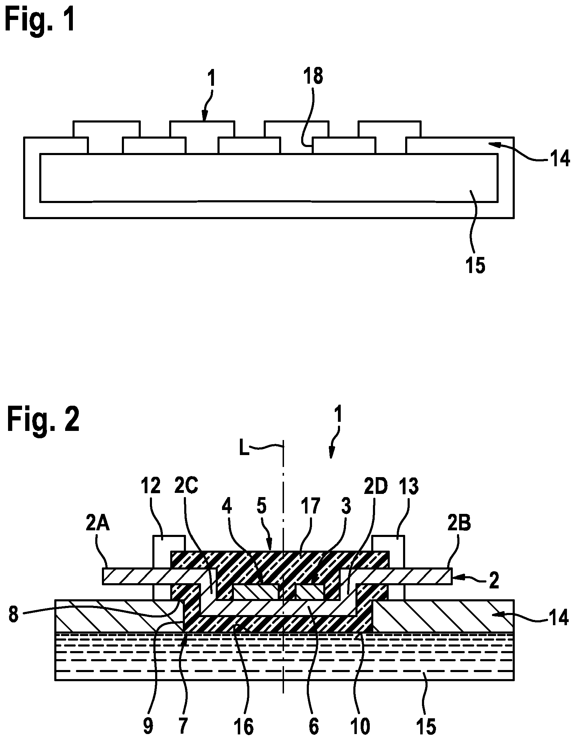

Nachfolgend werden unter Bezugnahme auf die Figuren 1 bis 4 besonders bevorzugte Ausführungsformen eines Elektronikmoduls 1 gemäß der vorliegenden Erfindung im Detail beschrieben.

Figur 1 zeigt eine Anordnung von im Beispielsfalle vier Elektronikmodulen, von denen repräsentativ für alle Elektronikmodule eines mit der Bezugsziffer 1 gekennzeichnet ist. Die Elektronikmodule 1 sind in zugeordneten Ausnehmungen 18 eines Kühlergehäuses 14 angeordnet. Das Kühlergehäuse 14 ist im Beispielsfalle ein Gehäuse, das als Kühlmedium Kühlwasser verwendet. Vom Prinzip her ist jedoch das erfindungsgemäße Elektronikmodul 1 auch mit anderen Kühlmedien, wie insbesondere Kühlluft, kombinierbar.

Das Elektronikmodul 1, das nachfolgend im Einzelnen anhand der Figuren 2 bis 4 beschrieben werden wird, dichtet bei dieser Ausführungsform die Ausnehmungen 18 ab, so dass es neben seiner eigentlichen Funktion als elektronisches Bauteil, beispielsweise als Messsensor, ohne weitere Bauteile auch die Ausnehmung 18 gegen den Austritt von Kühlwasser 15 abdichten kann.

In Figur 2 ist eine Detaildarstellung des Elektronikmoduls 1 wiedergegeben. Das Elektronikmodul 1 weist eine Trägerplatte (Stanzgitter/Substrat) 2 auf, die einen gegenüber Randbereichen 2A und 2B vertieften Zentralbereich 6 umfasst. Hieraus ergibt sich die aus Figur 2 im Einzelnen entnehmbare Konfiguration, die topfähnlich ausgestaltet ist. Die Randbereiche 2A und 2B sind hierbei über Verbindungsabschnitte 2C bzw. 2D mit dem Zentralbereich 6 verbunden. Wie Figur 2 zeigt, sind diese Verbindungsabschnitte 2C und 2D, im dargestellten Beispielsfall, im rechten Winkel zu den Randbereichen 2A und 2B sowie dem Zentralbereich 6 abgewinkelt.

Das Elektronikmodul 1 weist ferner ein Vergussgehäuse 5 auf, das die Trägerplatte 2 und auf dieser montierte elektronische Bauelemente 3, 4 ummantelt. Hierbei verdeutlicht Figur 2, dass die Dicke eines Bodens 16 des Vergussgehäuses 5, der benachbart zum vertieften Zentralbereich 6 angeordnet ist, geringer ist, als die Dicke einer Deckschicht 17, die die elektronischen Bauelemente 3 und 4 und die Oberseite des Zentralbereichs 6 ummantelt. Hierdurch ergibt sich der Vorteil, dass die Wärmeabfuhr in das Kühlwasser 15 verbessert wird, da die elektronischen Bauelemente 3 und 4 nahe dem Kühlmedium 15 angeordnet werden können. Das Elektronikmodul 1 kann am Kühlergehäuse 14 hierbei über Befestigungseinrichtungen 12 und 13 fixiert werden, die als Schrauben oder Klammern ausgebildet sein können.

Obwohl bei der Darstellung der Figur 2 zwei elektronische Bauelemente 3, 4 vorgesehen sind, ist es auch möglich, dass lediglich ein derartiges Bauelement oder auch eine Mehrzahl derartiger Bauelemente auf der Trägerplatte bzw. Leiterplatte 2 angeordnet werden können.

Das Vergussgehäuse 5 weist bei der dargestellten Ausführungsform ferner eine Dichteinrichtung 7 auf, die im Beispielsfalle von zwei Wandabschnitten 8 und 9 gebildet werden. Der Wandabschnitt 8 erstreckt sich hierbei in radialer Richtung, während der Wandabschnitt 9 ein longitudinaler Wandabschnitt ist, der sich also in Richtung der Längsachse L des Elektronikmoduls 1 erstreckt.

Obwohl durch eine derartige Anordnung zweier Wandabschnitte 8 und 9 eine ausreichende Dichteinrichtung 7 für das Kühlgehäuse 14 zur Verhinderung eines Austrittes von Kühlwasser 15 vorgesehen ist, können weitere Dichtelemente, wie beispielsweise Dichtkanten, Dichtlippen oder Dichthinterschnitte oder andere Dichtungen, wie z.B. O-Ringe, vorgesehen sein.

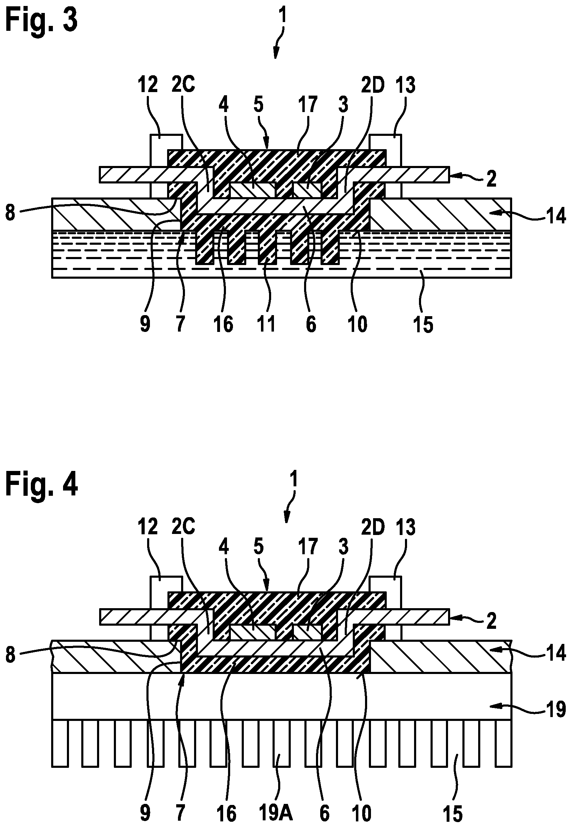

In Figur 3 ist eine zweite Ausführungsform des Elektronikmoduls 1 dargestellt, bei der alle Merkmale, die denjenigen der Figur 2 entsprechen, mit den gleichen Bezugsziffern versehen sind. Daher kann diesbezüglich auf die vorangehende Beschreibung der Figur 2 Bezug genommen werden.

Um die Kühleffizienz weiter zu verbessern, ist bei dieser Ausführungsform an der Unterseite 10 des Bodens 16 eine zusätzliche Kühlgeometrie vorgesehen, die aus einer Mehrzahl von rippenartig aufgebauten Wärmeableitelementen 11 besteht. Wie Figur 3 verdeutlicht, sind im Beispielsfalle fünf derartige Wärmeleitelemente 11 vorgesehen. Natürlich ist es möglich, ja nach Anwendungsfall auch eine geringere oder größere Anzahl derartiger Wärmeableitelemente 11 vorzusehen.

In Figur 4 ist eine weitere Ausführungsform des Elektronikmoduls 1 dargestellt, das in seinem Aufbau demjenigen der Figur 3 entspricht. Dementsprechend sind wiederum sämtliche übereinstimmende Bauteile mit denselben Bezugsziffern versehen und dementsprechend kann auf die voranstehende Beschreibung der Figur 2 Bezug genommen werden.

Figur 4 unterscheidet sich von den Ausführungsformen gemäß den Figuren 2 und 3 dadurch, dass das Elektronikmodul 1 über Befestigungseinrichtungen 12 und 13 mit einer Wärmeableitstruktur 19 versehen ist, die im Beispielsfalle fünfzehn Wärmeableitelemente 19A umfasst, in die Kühlwasser 15 eintreten kann, wobei diese Wärmeableitstruktur 19 wiederum eine vergrößerte Kühlfläche bildet, so dass die in das Kühlwasser 15 eingebrachte Wärme leichter abgeführt werden kann.

## Patentansprüche

1. Elektronikmodul (1)
- mit einer Trägerplatte (2);
- mit zumindest einem elektronischen Bauelement (3, 4), das auf der Trägerplatte (2) angeordnet ist; und
- mit einem Moldgussgehäuse (5),
**dadurch gekennzeichnet, dass**
das Moldgussgehäuse (5) die Trägerplatte (2) und das zumindest eine elektronische Bauelement (3, 4) ummantelt,
- wobei die Trägerplatte (2) einen vertieften Zentralbereich (6) aufweist, in dem das elektronische Bauelement (3, 4) angeordnet ist und
- wobei der den vertieften Zentralbereich (6) umgebende Teil des Moldgussgehäuses (5) zur Abdichtung gegenüber einer Ausnehmung, in die das Elektronikmodul einsetzbar ist, mit einer Dichteinrichtung (7) versehen ist.

2. Elektronikmodul nach Anspruch 1, **dadurch gekennzeichnet, dass** die Dichteinrichtung (7) von einem radialen und einem longitudinalen Wandabschnitt (8, 9) des Moldgussgehäuses (5) gebildet ist.

3. Elektronikmodul nach Anspruch 1 oder 2, **dadurch gekennzeichnet, dass** die Dichteinrichtung (7) Dichtkanten, Dichtlippen, Dichthinterschnitte und/oder sonstige Dichtungen, wie insbesondere O-Ringe, aufweist.

4. Elektronikmodul nach einem der Ansprüche 1 bis 3, **dadurch gekennzeichnet, dass** das Moldgussgehäuse (5) an seiner Unterseite (10) mit Wärmeableitelementen (11) versehen ist.

5. Elektronikmodul nach einem der Ansprüche 1 bis 4, **dadurch gekennzeichnet, dass** die Dicke des einem Kühlmedium (15) zugewandten Bodens (16) des Moldgussgehäuses (5) geringer ist, als die Materialstärke eines dem Kühlmedium (15) abgewandten Bereiches (17) des Moldgussgehäuses (5).

6. Elektronikmodul nach einem der Ansprüche 1 bis 5, **dadurch gekennzeichnet, dass** das Moldgussgehäuse (5) mittels Klammern oder Schrauben (12, 13) an einem Kühlgehäuse (14) befestigbar ist.

7. Verfahren zur Herstellung eines Elektronikmoduls (1), umfassend die Schritte:
a) Ausbilden einer Vertiefung (6) in einer Trägerplatte (2);
b) Bestücken der Trägerplatte (2) im Bereich der Vertiefung (6) mit wenigstens einem elektronischen Bauelement (3, 4), insbesondere ein Halbleiterelement,
c) Ummanteln der Trägerplatte (2) und des zumindest einem elektronischen Bauelements (3, 4) mit einer Moldmasse zur Ausbildung eines Moldgussgehäuses (5),
d) wobei der die Vertiefung (6) der Trägerplatte (2) umgebende Teil des Moldgussgehäuses (5) zur Abdichtung gegenüber einer Ausnehmung, in die das Elektronikmodul einsetzbar ist, mit einer Dichteinrichtung (7) versehen wird.

8. Verfahren nach Anspruch 7, wobei das Moldgussgehäuse (5) mittels einer Befestigungseinrichtung an einer Wärmeableitstruktur (19), insbesondere für die Kühlmedien Kühlwasser (15) oder Kühlluft, verbunden wird.

9. Verfahren nach Anspruch 7 oder 8, wobei die Trägerplatte derart ummantelt wird dass eine Dicke eines einem Kühlmedium zugewandten Bodens (16) des Moldgussgehäuses (5) geringer ist als eine Materialstärke eines dem Kühlmedium abgewandten Bereichs (17) des Moldgussgehäuses (5).

## Claims

1. Electronics module (1)
- comprising a carrier plate (2);
- comprising at least one electronic component (3, 4) which is arranged on the carrier plate (2); and
- comprising a moulded housing (5),
**characterized in that**
the moulded housing (5) encases the carrier plate (2) and the at least one electronic component (3, 4),
- wherein the carrier plate (2) has a recessed central region (6) in which the electronic component (3, 4) is arranged, and
- wherein that part of the moulded housing (5) which surrounds the recessed central region (6) is provided with a sealing device (7) for sealing off with respect to a recess into which the electronics module can be inserted.

2. Electronics module according to Claim 1, **characterized in that** the sealing device (7) is formed by a radial and a longitudinal wall section (8, 9) of the moulded housing (5).

3. Electronics module according to Claim 1 or 2, **characterized in that** the sealing device (7) has sealing edges, sealing lips, sealing undercuts and/or other seals, such as O-rings in particular.

4. Electronics module according to one of Claims 1 to 3, **characterized in that** the moulded housing (5) is provided with heat-dissipating elements (11) on its bottom side (10).

5. Electronics module according to one of Claims 1 to 4, **characterized in that** the thickness of the base (16) of the moulded housing (5), which base faces a cooling medium (15), is lower than the material thickness of a region (17) of the moulded housing (5), which region is averted from the cooling medium (15).

6. Electronics module according to one of Claims 1 to 5, **characterized in that** the moulded housing (5) can be fastened to a cooling housing (14) by means of clamps or screws (12, 13).

7. Method for producing an electronics module (1), comprising the steps of:
a) forming a recess (6) in a carrier plate (2);
b) populating the carrier plate (2) with at least one electronic component (3, 4), in particular a semiconductor element, in the region of the recess (6),
c) encasing the carrier plate (2) and the at least one electronic component (3, 4) with a moulding compound for forming a moulded housing (5),
d) wherein that part of the moulded housing (5) which surrounds the recess (6) in the carrier plate (2) is provided with a sealing device (7) for sealing off with respect to a recess into which the electronics module can be inserted.

8. Method according to Claim 7, wherein the moulded housing (5) is connected to a heat-dissipating structure (19), in particular for the cooling media cooling water (15) or cooling air, by means of a fastening device.

9. Method according to Claim 7 or 8, wherein the carrier plate is encased in such a way that a thickness of a base (16) of the moulded housing (5), which base faces a cooling medium, is lower than a material thickness of a region (17) of the moulded housing (5), which region is averted from the cooling medium.

## Revendications

1. Module électronique (1), comprenant
- une plaque de support (2) ;
- au moins un composant électronique (3, 4) qui est disposé sur la plaque de support (2) ; et
- un boîtier moulé (5),
**caractérisé en ce que**
le boîtier moulé (5) enveloppe la plaque de support (2) et l'au moins un composant électronique (3, 4),
- la plaque de support (2) présentant une zone centrale renfoncée (6) dans laquelle est disposé le composant électronique (3, 4) et
- la partie du boîtier moulé (5) entourant la zone centrale renfoncée (6), pour réaliser l'étanchéité par rapport à un évidement dans lequel peut être inséré le module électronique, étant pourvue d'un dispositif d'étanchéité (7).

2. Module électronique selon la revendication 1, **caractérisé en ce que** le dispositif d'étanchéité (7) est formé par une portion de paroi radiale et une portion de paroi longitudinale (8, 9) du boîtier moulé (5).

3. Module électronique selon la revendication 1 ou 2, **caractérisé en ce que** le dispositif d'étanchéité (7) présente des arêtes d'étanchéité, des lèvres d'étanchéité, des contre-dépouilles d'étanchéité et/ou d'autres joints d'étanchéité comme par exemple des joints toriques.

4. Module électronique selon l'une quelconque des revendications 1 à 3, **caractérisé en ce que** le boîtier moulé (5) est pourvu, au niveau de son côté inférieur (10), d'éléments de dissipation de la chaleur (11).

5. Module électronique selon l'une quelconque des revendications 1 à 4, **caractérisé en ce que** l'épaisseur du fond (16) du boîtier moulé (5) tourné vers un fluide de refroidissement (15) est plus petite que l'épaisseur de matériau d'une région (17) du boîtier moulé (5) opposée au fluide de refroidissement (15).

6. Module électronique selon l'une quelconque des revendications 1 à 5, **caractérisé en ce que** le boîtier moulé (5) peut être fixé à un boîtier de refroidissement (14) par des pinces ou des vis (12, 13).

7. Procédé de fabrication d'un module électronique (1), comprenant les étapes suivantes :
a) réalisation d'un renfoncement (6) dans une plaque de support (2) ;
b) équipement de la plaque de support (2) dans la région du renfoncement (6) avec au moins un composant électronique (3, 4), en particulier un élément semi-conducteur,
c) enveloppement de la plaque de support (2) et de l'au moins un composant électronique (3, 4) avec une masse de moulage pour réaliser un boîtier moulé (5),
d) la partie du boîtier moulé (5) entourant le renfoncement (6) de la plaque de support (2), pour réaliser l'étanchéité par rapport à un évidement dans lequel le module électronique peut être inséré, étant pourvue d'un dispositif d'étanchéité (7).

8. Procédé selon la revendication 7, dans lequel le boîtier moulé (5) est connecté au moyen d'un dispositif de fixation à une structure de dissipation de la chaleur (19), en particulier pour les fluides de refroidissement constitués par de l'eau de refroidissement (15) ou de l'air de refroidissement.

9. Procédé selon la revendication 7 ou 8, dans lequel la plaque de support est enveloppée de telle sorte qu'une épaisseur d'un fond (16) du boîtier moulé (5) tournée vers un fluide de refroidissement soit plus petite qu'une épaisseur de matériau d'une région (17) du boîtier moulé (5) opposée au fluide de refroidissement.
